# EUROPEAN PATENT SPECIFICATION

(11) **EP 1 922 820 B1**
(45) Date of publication and mention of the grant of the patent: **10.11.2010**
(21) Application number: 05808382.5
(22) Date of filing: 13.09.2005
(51) Int. Cl.: H04B 1/10, H03G 7/00, H04M 1/60

(54) **APPARATUS AND METHOD FOR REMOVING AMBIENT NOISE AND MOBILE COMMUNICATION TERMINAL EQUIPPED WITH THE APPARATUS**
VORRICHTUNG UND VERFAHREN ZUM ENTFERNEN VON UMGEBUNGSGERÄUSCHEN UND MIT DER VORRICHTUNG AUSGESTATTETES MOBILKOMMUNIKATIONSENDGERÄT
APPAREIL ET PROCEDE D'ELIMINATION DU BRUIT AMBIANT ET TERMINAL DE COMMUNICATION MOBILE EQUIPE DE L'APPAREIL

(30) Priority: 05.09.2005 KR 20050082380
(43) Date of publication of application: 21.05.2008
(73) Proprietor: Pishon Anc Co., Ltd., Seoul 156-811 (KR)
(72) Inventor: AHN, Hyun-kook, Seoul 156-095 (KR)
(74) Representative: Winter, Brandl, Fürniss, Hübner, Röss, Kaiser, Polte - Partnerschaft
(86) International application number: PCT/KR2005/003011
(87) International publication number: WO 2007/029899

(56) References cited:
- EP-A- 0 380 290
- JP-A- 61 099 451
- JP-A- 2005 086 361
- KR-A- 19980 041 437
- KR-B1- 870 001 636
- US-A- 4 891 837

## Description

### TECHNICAL FIELD

The present invention relates to an ambient noise removing apparatus and method and a mobile communication terminal having the apparatus, and more particularly, to an ambient noise removing apparatus and method and a mobile communication terminal equipped with the apparatus for removing an ambient noise inputted together with a user's voice signal or specific tone source, in communication equipment that receives the user's voice signal via microphone or sensor and sends it to a user's counterpart by wire or wireless or equipments receiving a specific tone source.

### BACKGROUND ART

As communication equipments that receive a voice signal from a user and transmit it to a user's counterpart by wire or wireless, there are for example a telephone used at home, a mobile communication terminal, etc. that are available in the course of movement, in addition to a head set device with radiotelegraph or microphone for voice communications and so on.

On the other hand, as equipments receiving a specific tone source, for instance, there exist an electric stethoscope that serves to hear arterial tone, intestinal noise, and blood vessel tone as well as heart tone or respiration tone that originates within the body to confirm whether they are under normal state, and a hydrostat that functions to detect a water leaking from pipe.

When the communication equipments receive a user's voice signal via microphone or sensor or the equipments receive a specific tone source via microphone or sensor, they also receive noises occurred in ambient area.

Especially, noises may often he introduced in the outside. For instance, there are a variety of noises: noise by ambient people, noise by public traffic means such as taxi, bus, etc., noise in the field of construction work, etc. And also, noises may he occurred in the inside as well as the outside. For example, noises necessarily tend to take place in closed places such as singing room furnished with karaoke, and in call centers answering inquiry phones from customers, and the like.

In case a user makes a voice call with a counterpart using the communication equipment such as the mobile communication terminal in the place of the inside or outside that introduces noises as set forth above, there may frequently occur an instance where the counterpart, i.e., recipient may not correctly understand the voice contents of the user, i.e., sender due to such noises.

As such, in the communication equipments, etc., which receive the user's voice signal or specific tone source via the microphone or sensor, the problem is that if they receive any noises occurred in ambient area together, the user's voice signal is not correctly transferred or only specific tone source is transferred due to the noises. To solve this problem, various methods or apparatuses have been developed. As one example, a circuit for removing an ambient noise incoming via microphone will be explained below referring to the accompanying drawing.

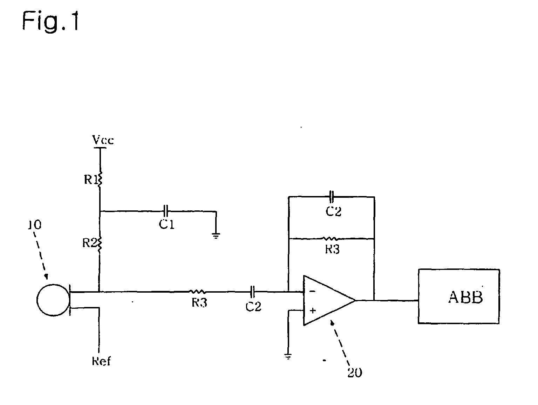

Fig. 1 shows a conventional circuit for removing an ambient noise incoming via microphone.

As illustrated in Fig. 1, when a conventional ambient noise removing circuit receives a voice signal from a user and an ambient noise signal via a microphone 10, it removes the noise signal through a condenser C2 coupled in series. The voice signal that the noise signal has been removed is amplified through an amplifier 20 and then outputted to the user via a speaker.

However, such a conventional noise removing circuit that removes the noise incoming via the microphone fails to remove a non-linear noise. In other words, the conventional noise removing circuit combines the non-linear noise and the inputted voice signal and then amplifies the combined signal, which still involves such non-leaner noise therein.

Document US-A-4 891 837 discloses a voice control circuit for a communication terminal, which controls the volume range of the voice signals. In a hands-free facility, the signal-to-noise ratio is lower than in telephones with handset. To avoid audible feedback, hands-free facility conventionally includes a volume control circuit which decreases or increases the gain in the receive path as the gain in the set path increases or decreases. In order to utilize the maximum possible loop gain without reducing the gain in the receive path, behind the microphone a controllable compandor is placed, in which the signal voltages from the microphone are A. compressed if they lie above a predetermined level, B. expanded if they lie below the predetermined level, and C. imparted maximum gain if they have the predetermined level. The predetermined signal level, which corresponds to the compression set point, is varied by a control circuit as a function of the ambient noise.

### DETAILED DESCRIPTION OF THE INVENTION

Accordingly, an object of the present invention is to provide an improved ambient noise removing apparatus and method and a mobile communication terminal employing the apparatus for removing an ambient noise.

The object is solved by the features of the independent claims. The dependent claims are directed to preferred embodiments of the invention.

In accordance with one aspect of the present invention, there is provided an ambient noise removing apparatus for removing a noise from a tone source with the noise inputted via a microphone or sensor, the apparatus comprising: a reference current setting unit for setting a reference current from the tone source inputted via the microphone or sensor, a variable amplifier having a gain controlled by the set reference current and for amplifying an input current of the tone source depending on the gain; and a level adjuster for adjusting a level of the tone source amplified through the variable amplifier.

The present invention as structured above sets a reference current from a valid tone signal with noise inputted via a microphone or sensor, and amplifies an input current of the tone source depending on a gain controlled by the set reference current, wherein the valid tone source is amplified more large and the noise is amplified more small. Accordingly, the invention has an advantage that the counter part can be heared only the valid tong signal removed the ambient noise.

In accordance with another aspect of the present invention, there is provided an ambient noise removing method for removing a noise from a tone source with the noise inputted via a microphone or sensor, the method comprising the steps of: setting a reference current from the tone source inputted via the microphone or sensor; obtaining a gain controlled by the set reference current and amplifying an input current of the tone source depending on the gain; and adjusting a level of the amplified tone source.

The present invention as constructed above sets a reference current from a valid tone signal with noise inputted via a microphone or sensor, and amplifies an input current of the tone source depending on a gain controlled by the set reference current, wherein the valid tone source is amplified more large and the noise is amplified more small. Thus, the invention has an advantage that the ambient noise can be removed.

In accordance with still another aspect of the present invention, there is provided a mobile communication terminal equipped with an ambient noise removing apparatus, comprising: a microphone for inputting a tone source from the outside; a reference current setting unit for setting a reference current from the tone source inputted via the microphone; a variable amplifier having a gain controlled by the set reference current and for amplifying an input current of the tone signal depending on the gain; a level adjuster for adjusting a level of the tone source amplified through the variable amplifier: and a voice signal processor for receiving and processing the tone source adjusted by the level adjuster.

The present invention as configured above sets a reference current from a valid tone signal with noise inputted via a microphone or sensor, and amplifies an input current of the tone source depending on a gain controlled by the set reference current, wherein the valid tone source is amplified more large and the noise is amplified more small. Accordingly, the invention has an advantage that the ambient noise can be removed.

### BRIEF DESCRIPTION OF THE DRAWINGS

These and other features, aspects, and advantages of preferred embodiments of the present invention will be more fully described in the following detailed description, taken accompanying drawings. In the drawings:
Fig. 1 shows a conventional ambient noise removing circuit for removing an ambient noise incoming via a microphone;
Fig. 2 is a graph representing an output level to an input level of a tone source in an ambient noise removing apparatus in accordance with the present invention;
Fig.3 illustrates an exemplary block configuration diagram of an ambient noise removing apparatus in accordance with an embodiment of the present invention;
Fig.4 provides an exemplary flowchart for explaining an ambient noise removing method in accordance with an embodiment of the present invention;
Fig.5 presents an exemplary circuitry diagram of an ambient noise removing apparatus in accordance with another embodiment of the present invention; and
Fig.6 is an exemplary block diagram of a mobile communication terminal provided with an ambient noise removing apparatus in accordance with yet another embodiment of the present invention.

### BEST MODE FOR CARRYING OUT THE INVENTION

A preferred embodiment of the present invention will now be described in detail with reference to the accompanying drawings. In the following description, if well-known functions or constructions would obscure the invention in unnecessary detail, a detailed description thereof will be omitted.

First of all, the principle of an ambient noise removing apparatus in accordance with an embodiment of the present invention will be described referring to the accompanying drawing.

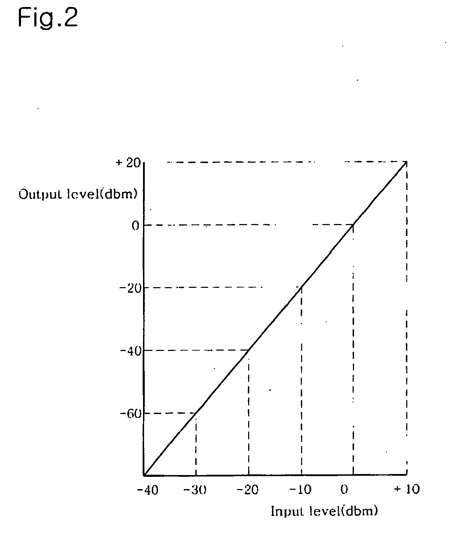

Fig. 2 shows a graph representing an output level to an input level of a tone source in an ambient noise removing apparatus in accordance with an embodiment of the present invention.

As illustrated in Fig. 2, in the ambient noise removing apparatus in accordance with the embodiment of the present invention, it can be seen that if an input level is +10 dBm, a corresponding output level is +20 dBm, and if an input level is -10 dBm, a corresponding output level is -20 dBm, wherein an input level of 0 dBm is a reference level. This means that if a certain input level greater than the reference level is applied, a greater output level is outputted, whereas if a certain input level less than the reference level is applied, a less output level is provided.

In the meantime, in case of sensible level inputted via a microphone at a position distanced by a certain interval from the microphone, an input level of a valid tone source as a user's voice signal is greater than noise occurred at an adjacent place, wherein this may be confirmed through the experiment. The position distanced by the certain interval refers to a position distanced by an interval less than 5 cm from the microphone. It may be preferable that the microphone is placed at a potion distanced by 2 cm from the mouse of the user.

Specifically, in case the user makes a call with an external counterpart using a mobile communication terminal at a place such as a singing room introducing a large noise, the mobile communication terminal's user and ambient people feel that the noise at the singing room is greater than a voice of the user using the mobile communication terminal.

However, in case of sensible level provided via the microphone at the position distanced by the certain interval from the microphone of the mobile communication terminal, a level of the noise at the singing room is less than the voice level of the user using the mobile communication terminal. The reason is that although the user's voice is inputted from the position distanced by a certain interval from the microphone of the mobile communication terminal via the microphone, the noise at the singing room is inputted from a farther location than the position distanced by the certain interval via the microphone. For this reason, there may cause an attenuation phenomenon between the microphone and the position distanced by the certain interval from the microphone, and therefore, a level of the noise becomes less than the voice level of the user using the mobile communication terminal at the position distanced by the certain interval from the microphone of the mobile communication terminal.

Now, the ambient noise removing apparatus in accordance with the embodiment of the invention using the principle and characteristic as set forth above will be described with reference to the accompanying drawings, wherein an example of removing the noise from the valid tone source including it inputted via the microphone will be given.

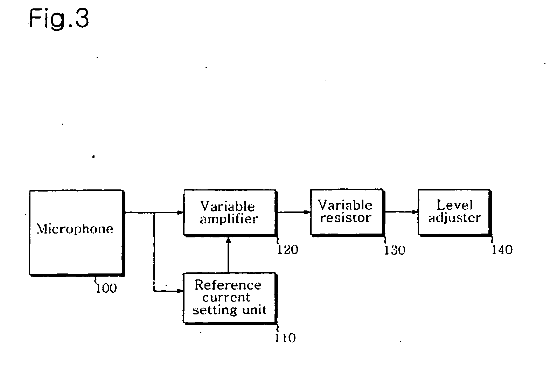

Fig. 3 illustrates an exemplary block configuration diagram of an ambient noise removing apparatus in accordance with an embodiment of the present invention.

As illustrated in Fig. 3, the inventive ambient noise removing apparatus for removing a noise from a valid tone source with the noise inputted via a microphone 100 comprises a reference current setting unit 110 for setting a reference current from the tone source inputted via the microphone 100, a variable amplifier 120 having a gain controlled by the set reference current and for amplifying a current of the inputted tone source according to the gain, and a level adjuster 140 for adjusting a level of the tone signal amplified through the variable amplifier 120. In addition, the inventive ambient noise removing apparatus further comprises a variable resistor 130 for determining an amplification ratio for the level adjuster 140 to adjust the level of the tone source.

The reference current setting unit 110 sets a reference current from the tone signal inputted via the microphone 100. Specifically, when the valid tone signal with the noise is inputted via the microphone 100, a certain voltage is inputted as an electrical signal corresponding to the inputted tone source and a current is created from the inputted voltage. The reference current setting unit 110 inputting the created current performs a full-wave rectification thereon and then sets the reference current using an average value outputted from the full-wave rectification.

The variable amplifier 120 has a gain controlled by the reference current set by the reference current setting unit 110 and amplifies a current of the inputted tone signal depending on the gain. And, the variable amplifier 120 inputs a current of the tone source with the noise inputted via the microphone 100 as in the reference current setting unit 110 and carries out a variable amplification with respect to an input current of the tone signal on the basis of the gain controller by the set reference current.

On the other hand, the gain of the variable amplifier 120 is proportional to the voltage of the tone source inputted via the microphone, meaning that the valid tone source greater than the reference current set by the reference current setting unit 110 is amplified more large while the noise less than the reference current is amplified more small.

More specifically, an input level of the valid tone source has a larger level than the noise at the location distanced by a certain interval from the microphone 100. If the valid tone source with the noise is inputted via the microphone 100, the reference current setting unit 110 outputs an average value of an input current of the valid tone source with the noise and then sets the reference current based on the average value. And then, the variable amplifier 120 conducts a variable amplification on the valid tone source with the noise based on the gain controlled by the set reference current, wherein the tone source greater than the reference current is amplified more large while the noise less than the reference current is amplified more small.

The variable resistor 130 is a variable one for determining an amplification ratio of the level adjuster 140 as described later.

The level adjuster 140 adjusts a level of the tone source amplified by the variable amplifier 120. This level adjuster 140 may he implemented by an operational amplifier and again amplifies the level of the tone source amplified by the variable amplifier 120 according to a certain amplification ratio to thereby adjust the level of the tone source. The certain amplification ratio is determined by the variable resistor 130.

In the meantime, it may be implemented that the ambient noise removing apparatus having the construction as mentioned above is controlled to operate as ON or OFF via a conversion switch by a manipulation of the user. Further, this ambient noise removing apparatus may be applied to all communication equipments including a general telephone, electrical stethoscope, radiotelegraph, mobile communication terminal, etc., and may also be provided as the form of a certain chip. Among them, an example of applying the ambient noise removing apparatus to the mobile communication terminal will be described later.

Hereinafter, an operation of the ambient noise removing apparatus having the construction as set forth above will be explained wherein it is assumed that the operation of the apparatus is under an ON state.

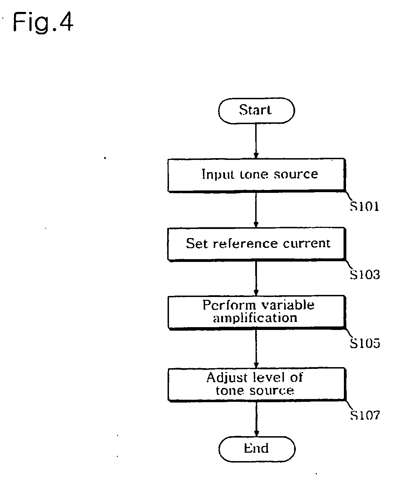

Fig. 4 provides an exemplary flowchart for explaining an ambient noise removing method in accordance with an embodiment of the present invention.

As illustrated in Fig. 4, the ambient noise removing method in accordance with the embodiment of the present invention first inputs a valid tone source with an ambient noise via a microphone or sensor at step S101. Subsequently, a certain voltage is applied as an electrical signal corresponding to the valid tone source with the inputted ambient noise, and a current is created from the applied voltage. At step S103. the reference current setting unit 110 inputting the created current performs a full-wave rectification with respect to the inputted current and sets the reference current using an average value provided from the full wave rectification.

Meanwhile, the variable amplifier 120 inputs, at step S105, the current of the valid tone source with the ambient noise via the microphone or sensor, as in the reference current setting unit 110, and then carries out a variable amplification with respect to the inputted current according to the gain controlled by the reference current set by the reference current setting unit 110. Through such variable amplification process at step S105, the valid tone source is amplified more large and the ambient noise is amplified more small. As a result, the ambient noise can be removed.

At a next step S107, the level adjuster 140 again amplifies the current amplified by the variable amplifier 120 according to a certain amplification ratio to thereby adjust the level of the tone source.

Now, an ambient noise removing apparatus in accordance with another embodiment of the invention will be described with reference to the accompanying drawings, wherein an example of removing the noise from the valid tone source with it inputted via the microphone will be given.

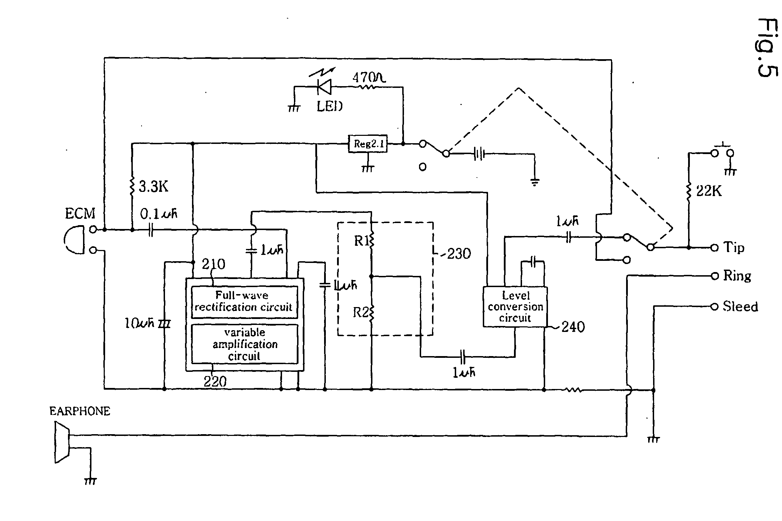

Fig.5 shows an exemplary circuitry diagram for explaining an ambient noise removing apparatus in accordance with another embodiment of the present invention.

As illustrated in Fig. 5, the ambient noise removing apparatus in accordance with another embodiment of the invention comprises a full-wave rectification circuit 210 whose input terminal is coupled with a voice signal inputted from a microphone and output terminal outputting a rectified current is connected to a gain control terminal of a variable amplification circuit, the variable amplification circuit 220 whose input terminal is coupled with the voice signal from the microphone, the gain control terminal is connected to the output terminal of the full-wave rectification circuit 210, and output terminal outputting an amplified current is connected to an input terminal of a level conversion circuit via a resistor, and the level conversion circuit 240 for inputting a current from the output terminal of the variable amplification circuit via the resistor, and amplifying the current based on a certain gain and outputting the amplified current via the output terminal.

In addition, the ambient noise removing apparatus further comprises a variable resistor circuit 230 for determining the certain gain used in amplifying the signal at the level conversion circuit 240.

The full-wave rectification circuit 210 sets the reference current from the tone source inputted via ECM (Electronic Condenser Microphone) as shown. Specifically, if the valid tone source with the noise is inputted via the microphone, a certain voltage is applied as an electrical signal corresponding to the inputted tone source and a current is produced from the applied voltage. The full-wave rectification circuit 210 inputting the produced current conducts a full-wave rectification with respect to the inputted current and then sets the reference current using an average value derived from the full-wave rectification.

The variable amplification circuit 220, which has a gain controlled by the reference current set by the full-wave rectification circuit 210, amplifies an input current of the tone source according to the gain. And, the variable amplification circuit 220 inputs the current of the valid tone source with the noise via the microphone, as in the full wave rectification circuit 210, and then performs a variable amplification with respect to the inputted current according to the gain controlled by the reference current.

The level conversion circuit 240 again amplifies the level of the tone source amplified by the variable amplification circuit 220 depending on a certain amplification ratio to thereby regulate the level of the tone source.

And, the output terminal of the level conversion circuit 240 may be electrically connected to a microphone's input terminal of the mobile communication terminal, and also to the mobile communication terminal via a connection terminal for hands free provided by a certain connection standard, wherein if the ambient noise removing apparatus is coupled via the connection terminal, it may be implemented in such a manner that the microphone of the mobile communication terminal itself becomes automatically OFF.

In the meantime, as shown in Fig. 5, the ambient noise removing apparatus in accordance with another embodiment of the present invention comprises a conversion switch to make its operation as ON or OFF, a regulator for supplying a power to circuits involved therein for their driving, etc. The resistor, condenser, etc. which are not explained above are used for driving and stability of circuits, wherein details thereof are omitted for the sake of brevity.

Now, a mobile communication terminal comprising the ambient noise removing apparatus in accordance with another embodiment of the invention will be described with reference to the accompanying drawing.

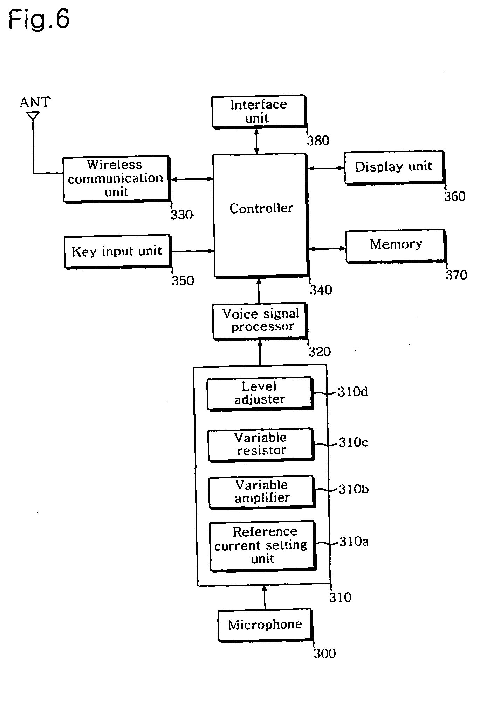

Fig. 6 illustrates an exemplary block diagram of a mobile communication terminal equipped with the ambient noise removing apparatus in accordance with another embodiment of the present invention.

As shown in Fig. 6, the mobile communication terminal including the ambient noise removing apparatus 310 in accordance with another embodiment of the present invention comprises a microphone 300 for inputting a tone source from the outside, a reference current setting unit 310a for setting a reference current from the tone signal inputted via the microphone 300, a variable amplifier 310b having a gain controlled by the set reference current and amplifying an input current of the tone signal depending on the gain, a level adjuster 310d for adjusting a level of the tone signal amplified through the variable amplifier 310b, and a voice signal processor 320 for receiving and processing the tone signal adjusted by the level adjuster 310d. The mobile communication terminal further comprises a variable resistor 310c for determining an amplification ratio for the level adjuster 310d to adjust the level of the tone source.

In addition, the mobile communication terminal equipped with the ambient noise removing apparatus 310 further comprises a wireless communication unit 330, a controller 340, a key input unit 350, a display unit 360, a memory 370, and an interface 380, which are commonly involved in the existing mobile communication terminal.

Specifically, the reference current setting unit 310a sets a reference current of a tone source inputted from the microphone 300. In other words, if the valid tone source with noise is inputted via the microphone 300, a certain voltage is applied as an electrical signal corresponding to the inputted tone source and a current is created from the applied voltage. The reference current setting unit 310a inputting the created current performs a full-wave rectification on the inputted current and then sets the reference current using an average value provided from the full wave rectification.

The variable amplifier 310b has a gain controlled by the reference current set by the reference current setting unit 310a and amplifies an input current of the tone source depending on the gain. And, the variable amplifier 310b inputs the current of the valid tone source with the noise via the microphone, as in the reference current setting unit 310a, and then carries out a variable amplification with respect to the inputted current according to the gain controlled by the set reference current.

The level adjuster 310d adjusts a level of the tone source amplified by the variable amplifier 310b. This level adjuster 310d may be implemented by an operational amplifier and again amplifies the level of the amplified tone source according to a certain amplification ratio.

The voice signal processor 320 converts digital voice data into analog voice signal or conversely performs the reverse conversion; and is a well-known unit, including additional circuits such as an audio amplifier and filter, which inputs and processes the tone source adjusted by the level adjuster 310d. This voice signal processor 320 may be a voice codec.

The wireless communication unit 330 is configured to include an antenna and an RF circuit for communicating with a base station. The wireless communication unit 330 used herein should be interpreted to include mobile communication systems to be introduced in the future as well as the existing systems such as cellular, GSM, W-CDMA systems, etc., in addition to various versions of CDMA systems.

The controller 340 controls the whole operation of the mobile communication terminal. And, the key input unit 350 is configured to include a multiplicity of numeric keys, character keys, and functional keys, and transfers a signal to the controller 340 when inputting the instructions of the user. The display unit 360 displays the whole operational status of the mobile communication terminal.

The memory 370 may be a nonvolatile memory such as EEPROM or flash memory, and stores programs necessary for driving the data and mobile communication terminal.

The interface unit 380 may be a communication port for connecting the mobile communication terminal to external equipments and is connected to the external equipments via a certain communication cable.

The ambient noise removing apparatus as set forth above may be included in the mobile communication terminal, and may also be implemented to include in car microphone provided with the mobile communication terminal. In this case, the ambient noise removing apparatus may be also ON or OFF, according to the manipulation of the user.

Further, the ambient noise removing apparatus is connected to the interface unit 380 via the communication cable that depends on the connection standard of the input and output terminals of the mobile communication terminal and may be implemented to operate even when inputting audio signal. At this time, if the ambient noise removing apparatus is connected through the interface unit 380 of the mobile communication terminal, it may be implemented that the operation of the microphone of the mobile communication terminal itself becomes ON or OFF. In this case, if the operation of the ambient noise removing apparatus is ON, such is possible because the mobile communication terminal inputs and processes a corresponding signal.

On the other hand, the connection standard includes TTA24PIN, and if the connection standard will be amended in the future, the ambient noise removing apparatus may connect to the mobile communication terminal according to the new connection standard amended. For reference, among the pins of the input and output terminals of TTA24PIN, the 7^{th} pin is used as a pin for AUDIO IN/PCM RX.

### INDUSTRIAL APPLICABILITY

As described above, the present invention sets a reference current from a valid tone signal with noise inputted via a microphone or sensor, and amplifies an input current of the tone source depending on a gain controlled by the set reference current, wherein the valid tone source is amplified more large and the noise is amplified more small to thereby remove the ambient noise.

Although the present invention has been described in connection with the exemplary embodiments illustrated in the drawings, it is only illustrative. It will be understood by those skilled in the art that various modifications and equivalents can be made to the present invention. Therefore, the true technical scope of the present invention should be defined by the appended claims.

## Claims

1. An ambient noise removing apparatus for removing a noise from a tone source with the noise inputted via a microphone (100, 300) or sensor, the apparatus comprising:
a variable amplifier (120, 310b, 220) having a gain for amplifying an input current of the tone source depending on the gain; and
a level adjuster (140, 310d, 240) for adjusting a level of the tone source amplified through the variable amplifier (120, 310b, 220);
**characterized by**
a reference current setting unit (110, 310a) for receiving a current of the tone source input via the microphone (100, 300) or sensor, and providing an average of the current as a reference current to the variable amplifier (120, 310b, 220);
said gain being controlled by the set reference current such that the variable amplifier (120, 310b, 220) is adapted to, if the input current of the tone source is greater than the reference current, amplify the input current proportionally to a voltage of the tone source input via the microphone (100, 300) or sensor, and if the input current of the tone source is less than the reference current, attenuate the input current proportionally to the voltage of the tone source input via the microphone (100, 300) or sensor.

2. The apparatus as recited in claim 1, wherein the level adjuster (140, 310d, 240) is an operational amplifier.

3. The apparatus as recited in claim 1, wherein the operation of the apparatus is ON or OFF by a manipulation of a user.

4. The apparatus as recited in claim 1, wherein the apparatus is connected to a mobile communication terminal.

5. The apparatus as recited in claim 4, wherein the apparatus is included, as a single unit, in an ear microphone (100, 300) provided with a mobile communication terminal, and the apparatus and the ear microphone (100, 300) are connected.

6. The apparatus as recited in claim 4, wherein the apparatus is connected to input and output terminals of the mobile communication terminal provided by a connection standard.

7. The apparatus as recited in claim 1, wherein the apparatus is included in an electric stethoscope or radiotelegraph.

8. An ambient noise removing method for removing a noise from a tone source with the noise inputted via a microphone (100, 300) or sensor, the method comprising the steps of:
obtaining a gain and amplifying an input current of the tone source depending on the gain;
adjusting a level of the amplified tone source;
**characterized by**
providing an average current from the tone source inputted via the microphone (100, 300) or sensor and setting the average current as a reference current;
controlling the gain by the set reference current such that when the input current of the tone source is greater than the reference current, amplifying the input current proportionally to a voltage of the tone source input via the microphone (100, 300) or sensor, and when the input current of the tone source is less than the reference current, attenuating the input current proportionally to the voltage of the tone source input via the microphone (100, 300) or sensor.

9. The method recited in claim 8, wherein the reference current setting step comprises the steps of:
receiving a current of the tone source inputted via the microphone (100, 300) or sensor;
performing a full-wave rectification with respect to the received current; and
outputting the full-wave rectified current to thereby set the reference current.

10. The method recited in claim 8, wherein the level adjusting step adjusts the level of the tone source in accordance with a preset amplification ratio.

11. The method recited in claim 8, further comprising the step of making the process of the method as ON or OFF by a manipulation of a user.

12. A mobile communication terminal equipped with an ambient noise removing apparatus according to any one of claims 1 to 7, comprising:
a microphone (100, 300) for inputting a tone source from the outside; and
a voice signal processor (320) for receiving and processing the tone source adjusted by the level adjuster (.140, 310d, 240).

13. An ambient noise removing apparatus according to any one of claims 1 to 7, the apparatus further comprising:
a full-wave rectification circuit (210) whose input terminal receives a voice signal inputted from a microphone (100, 300) or sensor as said input current, and whose output terminal outputting a rectified current is connected to a gain control terminal of said variable amplification circuit;
the variable amplification circuit having an input terminal receiving the voice signal from the microphone (100, 300) or sensor, and an output terminal outputting an amplified current and being connected to an input terminal of said level adjuster via a resistor; and
the level adjuster receiving the current from the output terminal of the variable amplification circuit via the resistor, and amplifying the current according to a certain gain to output an amplified signal via an output terminal.

14. The apparatus as recited in claim 13, wherein the output terminal of the level adjuster is electrically connected to a microphone input terminal of a mobile communication terminal.

15. The apparatus as recited in claim 13, wherein, the output terminal of the level adjuster is coupled with a mobile communication terminal via a connection terminal for hands free provided by a certain connection standard.

16. The apparatus as recited in claim 15, wherein if the apparatus is electrically connected to the mobile communication terminal via the connection terminal, the operation of the microphone (100, 300) of the mobile communication terminal itself is automatically OFF.

## Patentansprüche

1. Umgebungsrauschenentfernungsvorrichtung zum Entfernen eines Rauschens von einer Tonquelle, wobei das Rauschen über ein Mikrofon (100, 300) oder einen Sensor eingegeben wird, wobei die Vorrichtung aufweist:
einen variablen Verstärker (120, 310b, 220), der eine Verstärkung zum Verstärken eines Eingangsstromes einer Tonquelle in Abhängigkeit von der Verstärkung aufweist;
einen Pegeleinsteller (140, 310d, 240) zum Einstellen eines Pegels der Tonquelle, die durch den variablen Verstärker verstärkt wird (120, 310b, 220);
**gekennzeichnet durch**
eine Bezugsstromeinstelleinheit (110, 310a) zum Empfangen eines Stromes der Tonquelle, die über das Mikrofon (100, 300) oder den Sensor eingegeben wird, und zum Bereitstellen eines Mittelwertes des Stromes als einen Bezugsstrom für den variablen Verstärker (120, 310b, 220);
wobei die Verstärkung **durch** den eingestellten Bezugsstrom derart gesteuert wird, dass der variable Verstärker (120, 310b, 220) ausgelegt ist, wenn der Eingangsstrom der Tonquelle größer als der Bezugsstrom ist, den Eingangsstrom proportional zu einer Spannung der Tonquelle, die über das Mikrofon (100, 300) oder den Sensor eingegeben wird, zu verstärken, und wenn der Eingangsstrom der Tonquelle kleiner als der Bezugsstrom ist, den Eingangsstrom proportional zu der Spannung der Tonquelle, die über das Mikrofon (100, 300) oder den Sensor eingegeben wird, abzuschwächen.

2. Vorrichtung nach Anspruch 1, wobei der Pegeleinsteller (140, 310d, 240) ein Operationsverstärker ist.

3. Vorrichtung nach Anspruch 1, wobei der Betrieb der Vorrichtung ein EIN oder AUS durch Betätigung eines Nutzers ist.

4. Vorrichtung nach Anspruch 1, wobei die Vorrichtung mit einem mobilen Kommunikationsterminal verbunden ist.

5. Vorrichtung nach Anspruch 4, wobei die Vorrichtung als eine einzelne Einheit in einem Ohr-Mikrofon (100, 300), das mit einem mobilen Kommunikationsterminal bereitgestellt wird, enthalten ist und die Vorrichtung und das Ohr-Mikrofon (100, 300) miteinander verbunden sind.

6. Vorrichtung nach Anspruch 4, wobei die Vorrichtung mit Eingangs- und Ausgangsanschlüssen des mobilen Kommunikationsterminals gemäß einem Verbindungsstandard verbunden ist.

7. Vorrichtung nach Anspruch 1, wobei die Vorrichtung in einem elektrischen Stethoskop oder einer Radiotelegraphieeinrichtung enthalten ist.

8. Umgebungsrauschenentfernungsverfahren zum Entfernen eines Rauschens von einer Tonquelle, wobei das Rauschen über ein Mikrofon (100, 300) oder einen Sensor eingegeben wird, wobei das Verfahren die folgenden Schritte aufweist:
Erhalten einer Verstärkung und Verstärken eines Eingangsstromes der Tonquelle in Abhängigkeit von der Verstärkung;
Einstellen eines Pegels der verstärkten Tonquelle;
**gekennzeichnet durch**
Bereitstellen eines mittleren Stromes von der Tonquelle, die über das Mikrofon (100, 300) oder den Sensor eingegeben wird, und Einstellen des mittleren Stromes als einen Bezugsstrom;
Steuern der Verstärkung **durch** den eingestellten Bezugsstrom derart, dass, wenn der Eingangsstrom der Tonquelle größer als der Bezugsstrom ist, der Eingangsstrom proportional zu einer Spannung der Tonquelle, die über das Mikrofon (100, 300) oder den Sensor eingegeben wird, verstärkt wird, und wenn der Eingangsstrom der Tonquelle kleiner als der Bezugsstrom ist, der Eingangsstrome proportional zu der Spannung der Tonquelle, die über das Mikrofon (100, 300) oder den Sensor eingegeben wird, abgeschwächt wird.

9. Verfahren nach Anspruch 8, wobei der Bezugsstromeinstellschritt die folgenden Schritte aufweist:
Empfangen eines Stromes der Tonquelle, die über das Mikrofon (100, 300) oder den Sensor eingegeben wird;
Durchführen einer Vollwellengleichrichtung in Bezug auf den empfangenen Strom;
Ausgeben des vollwellengleichgerichteten Stromes, um **dadurch** den Bezugsstrom einzustellen.

10. Verfahren nach Anspruch 8, wobei der Pegeleinstellschritt den Pegel der Tonquelle entsprechend einem voreingestellten Verstärkungsverhältnis einstellt.

11. Verfahren nach Anspruch 8, das außerdem den Schritt des Durchführens von EIN oder AUS durch Betätigung eines Nutzers aufweist.

12. Mobiles Kommunikationsterminal, das mit einer Umgebungsrauschenentfernungsvorrichtung nach einem der Ansprüche 1 bis 7 ausgerüstet ist, und das aufweist:
ein Mikrofon (100, 300) zum Eingeben einer Tonquelle von außen;
einen Sprachsignalprozessor (320) zum Empfangen und Verarbeiten der Tonquelle, die durch den Pegeleinsteller (140, 310d, 240) eingestellt wird.

13. Umgebungsrauschenentfernungsvorrichtung nach einem der Ansprüche 1 bis 7, wobei die Vorrichtung außerdem aufweist:
eine Vollwellengleichrichtungsschaltung (210), deren Eingangsanschluss ein Sprachsignal, das von einem Mikrofon (100, 300) oder einem Sensor eingegeben wird, als den Eingangsstrom empfängt, und deren Ausgangsanschluss, der einen gleichgerichteten Strom ausgibt, mit einem Verstärkungssteueranschluss der variablen Verstärkungsschaltung verbunden ist,
wobei die variable Verstärkungsschaltung einen Eingangsanschluss, der das Sprachsignal von dem Mikrofon (100, 300) oder dem Sensor empfängt, und einen Ausgangsanschluss, der einen verstärkten Strom ausgibt und mit einem Eingangsanschluss des Pegeleinstellers über einen Widerstand verbunden ist, aufweist;
der Pegeleinsteller den Strom von dem Ausgangsanschluss der variablen Verstärkungsschaltung über den Widerstand empfängt und den Strom entsprechend einer bestimmten Verstärkung verstärkt, um ein verstärktes Signal über einen Ausgangsanschluss auszugeben.

14. Vorrichtung nach Anspruch 13, wobei der Ausgangsanschluss des Pegeleinstellers elektrisch mit einem Mikrofoneingangsanschluss eines mobilen Kommunikationsterminals verbunden ist.

15. Vorrichtung nach Anspruch 13, wobei der Ausgangsanschluss des Pegeleinstellers mit einem mobilen Kommunikationsterminal über einen Verbindungsanschluss zum Freihandbetrieb gemäß einem bestimmten Verbindungsstandard gekoppelt ist.

16. Vorrichtung nach Anspruch 15, wobei, wenn die Vorrichtung mit dem mobilen Kommunikationsanschluss über den Verbindungsanschluss verbunden ist, der Betrieb des Mikrofons (100, 300) des mobilen Kommunikationsanschlusses selbst automatisch AUS ist.

## Revendications

1. Appareil de suppression de bruit ambiant pour supprimer un bruit d'une source de tonalité avec le bruit entré à l'aide d'un microphone (100, 300) ou d'un capteur, l'appareil comprenant :
un amplificateur variable (120, 310b, 220) ayant un gain pour amplifier un courant d'entrée de la source de tonalité en fonction du gain ; et
un ajusteur de niveau (140, 310d, 240) pour ajuster un niveau de la source de tonalité amplifiée par l'intermédiaire de l'amplificateur variable (120, 310b, 220) ;
**caractérisé par**
une unité d'établissement de courant de référence (110, 310a) pour recevoir un courant de la source de tonalité entrée à l'aide du microphone (100, 300) ou du capteur, et fournir une moyenne du courant comme courant de référence à l'amplificateur variable (120, 310b, 220) ;
ledit gain étant commandé par le courant de référence établi de sorte que l'amplificateur variable (120, 310b, 220) soit adapté pour, si le courant d'entrée de la source de tonalité est supérieur au courant de référence, amplifier le courant d'entrée proportionnellement à une tension de la source de tonalité entrée à l'aide du microphone (100, 300) ou du capteur et, si le courant d'entrée de la source de tonalité est inférieur au courant de référence, atténuer le courant d'entrée proportionnellement à la tension de la source de tonalité entrée à l'aide du microphone (100, 300) ou du capteur.

2. Appareil selon la revendication 1, dans lequel l'ajusteur de niveau (140, 310d, 240) est un amplificateur opérationnel.

3. Appareil selon la revendication 1, dans lequel le fonctionnement de l'appareil est MARCHE ou ARRET par une manipulation d'un utilisateur.

4. Appareil selon la revendication 1, dans lequel l'appareil est connecté à un terminal de communication mobile.

5. Appareil selon la revendication 4, dans lequel l'appareil est inclus, comme une seule unité, dans un microphone pour l'oreille (100, 300) fourni avec un terminal de communication mobile, et l'appareil et le microphone pour l'oreille (100, 300) sont connectés.

6. Appareil selon la revendication 4, dans lequel l'appareil est connecté à des bornes d'entrée et de sortie du terminal de communication mobile fournies par un standard de connexion.

7. Appareil selon la revendication 1, dans lequel l'appareil est inclus dans un stéthoscope électrique ou un radiotélégraphe.

8. Procédé de suppression de bruit ambiant pour supprimer un bruit d'une source de tonalité avec le bruit entré à l'aide d'un microphone (100, 300) ou d'un capteur, le procédé comprenant les étapes consistant à :
obtenir un gain et amplifier un courant d'entrée de la source de tonalité en fonction du gain ;
ajuster un niveau de la source de tonalité amplifiée ;
**caractérisé par**
la fourniture d'un courant moyen depuis la source de tonalité entrée à l'aide du microphone (100, 300) ou du capteur et l'établissement du courant moyen comme courant de référence ;
la commande du gain par le courant de référence établi de sorte que lorsque le courant d'entrée de la source de tonalité est supérieur au courant de référence, amplifier le courant d'entrée proportionnellement à une tension de la source de tonalité entrée à l'aide du microphone (100, 300) ou du capteur, et lorsque le courant d'entrée de la source de tonalité est inférieur au courant de référence, atténuer le courant d'entrée proportionnellement à la tension de la source de tonalité entrée à l'aide du microphone (100, 300) ou du capteur.

9. Procédé selon la revendication 8, dans lequel l'étape d'établissement de courant de référence comprend les étapes consistant à :
recevoir un courant de la source de tonalité entrée à l'aide du microphone (100, 300) ou du capteur ;
effectuer un redressement pleine onde relativement au courant reçu ; et
sortir le courant redressé pleine onde pour établir ainsi le courant de référence.

10. Procédé selon la revendication 8, dans lequel l'étape d'ajustement de niveau ajuste le niveau de la source de tonalité conformément à un rapport d'amplification préétabli.

11. Procédé selon la revendication 8, comprenant en outre l'étape consistant à rendre le processus du procédé comme MARCHE ou ARRET par une manipulation d'un utilisateur.

12. Terminal de communication mobile équipé d'un appareil de suppression de bruit ambiant selon l'une quelconque des revendications 1 à 7, comprenant :
un microphone (100, 300) pour entrer une source de tonalité depuis l'extérieur ; et
un processeur de signal vocal (320) pour recevoir et traiter la source de tonalité ajustée par l'ajusteur de niveau (140, 310d, 240).

13. Appareil de suppression de bruit ambiant selon l'une quelconque des revendications 1 à 7, l'appareil comprenant en outre :
un circuit de redressement pleine onde (210) dont la borne d'entrée reçoit un signal vocal entré depuis un microphone (100, 300) ou un capteur comme ledit courant d'entrée, et dont la borne de sortie sortant un courant redressé est connectée à une borne de commande de gain dudit circuit d'amplification variable ;
le circuit d'amplification variable ayant une borne d'entrée recevant le signal vocal depuis le microphone (100, 300) ou le capteur, et une borne de sortie sortant un courant amplifié et étant connectée à une borne d'entrée dudit ajusteur de niveau par l'intermédiaire d'une résistance ; et
l'ajusteur de niveau recevant le courant de la borne de sortie du circuit d'amplification variable par l'intermédiaire de la résistance, et amplifiant le courant selon un certain gain pour sortir un signal amplifié par l'intermédiaire d'une borne de sortie.

14. Appareil selon la revendication 13, dans lequel la borne de sortie de l'ajusteur de niveau est connectée électriquement à une borne d'entrée de microphone d'un terminal de communication mobile.

15. Appareil selon la revendication 13, dans lequel la borne de sortie de l'ajusteur de niveau est couplée avec un terminal de communication mobile par l'intermédiaire d'une borne de connexion pour mains libres fournie par un certain standard de connexion.

16. Appareil selon la revendication 15, dans lequel si l'appareil est connecté électriquement au terminal de communication mobile par l'intermédiaire de la borne de connexion, le fonctionnement du microphone (100, 300) du terminal de communication mobile même est automatiquement sur ARRET.
